**Europäisches Patentamt**

**European Patent Office**

**Office européen des brevets**

(19)

(11) Numéro de publication : **0 565 435 A1**

## (12) DEMANDE DE BREVET EUROPEEN

(21) Numéro de dépôt : **93400893.9**

(22) Date de dépôt : **06.04.93**

(51) Int. Cl.[5] : **H01L 27/06,** H01L 29/76, H01L 29/36

(30) Priorité : **07.04.92 FR 9204216**

(43) Date de publication de la demande :
**13.10.93 Bulletin 93/41**

(84) Etats contractants désignés :
**DE GB NL**

(71) Demandeur : **THOMSON-CSF
SEMICONDUCTEURS SPECIFIQUES
51 Esplanade du Général de Gaulle
F-92800 Puteaux (FR)**

(72) Inventeur : **Perea, Ernesto
Thomson-CSF, SCPI, BP 329
F-92402 Courbevoie Cedex (FR)**
Inventeur : **De Lagebeaudeuf, Daniel
Thomson-CSF, SCPI, BP 329
F-92402 Courbevoie Cedex (FR)**

(74) Mandataire : **Taboureau, James et al
THOMSON-CSF, SCPI, B.P. 329, 50, rue
Jean-Pierre Timbaud
F-92402 Courbevoie Cédex (FR)**

(54) **Dispositif semiconducteur à transistors complémentaires.**

(57) L'invention décrit un système à au moins deux transistors complémentaires, à canaux n et p, mais comportant une hétérostructure entre matériaux III-V.

Afin d'équilibrer les tensions de seuils dans les deux canaux n (2 DEG) et p (2GHG), au moins deux plans de dopage p (19) et n (20) sont inclus dans deux couches de l'hérostructure, à des niveaux compris entre les canaux (2 DEG, 2 DHG) et les électrodes de grilles (7,8). Le plan de dopage n (20) est ensuite supprimé par gravure localisée à l'aplomb du transistor à canal p.

Application à la logique rapide.

FIG.5

EP 0 565 435 A1

La présente invention concerne un dispositif semiconducteur comportant au moins deux transistors de types complémentaires et formés autour d'une hétérostructure entre matériaux des groupes III-V. L'une des particularités de ce dispositif est que sa structure permet d'équilibrer les tensions de seuils $V_T$ des deux transistors de types n et p, et d'optimiser leurs transconductances, malgré les différences de mobilités entre les électrons et les trous.

L'un des objets de ce dispositif est de réduire la consommation électrique des circuits logiques rapides et des circuits hyperfréquences.

Il est connu qu'en logique rapide ce sont, jusqu'à présent, exclusivement les transistors de type n qui sont utilisés, parce que les électrons ont dans le canal une mobilité beaucoup plus élevée que les trous, ce qui communique aux transistors une plus haute fréquence de coupure.

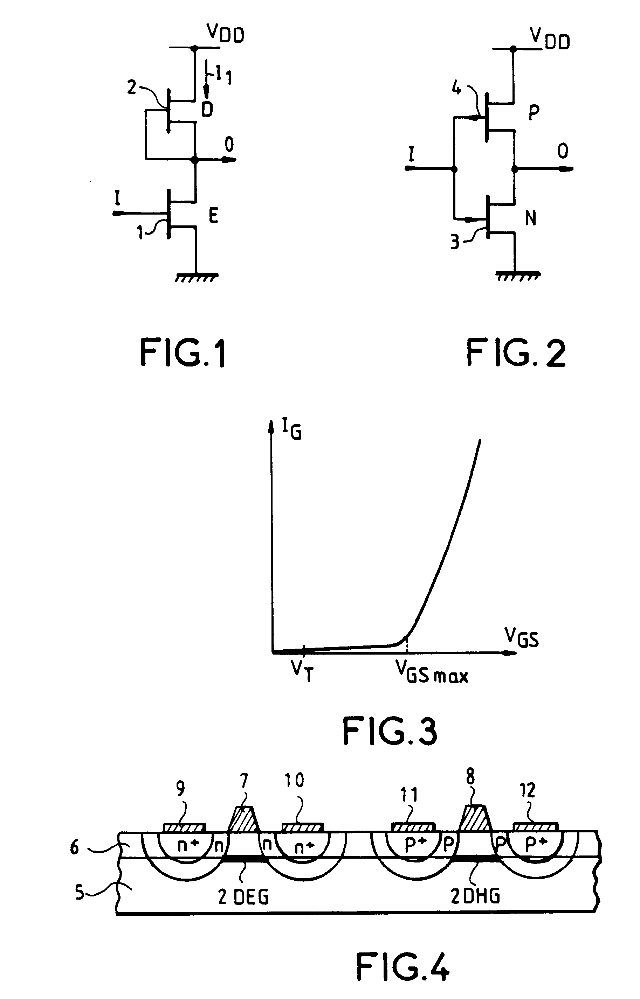

Il est également connu que la cellule de base en logique est l'inverseur, tel que représenté en figure 1. Cet inverseur de type DCFL (Direct Coupled Fet Logic, en anglais) est composé d'un transistor d'entrée 1 de type n à enrichissement, monté en série avec une charge active 2 de type n à déplétion, l'ensemble étant alimenté entre la masse et une tension $V_{DD}$. Le signal d'entrée est appliqué en I sur la grille du transistor 1 et le signal de sortie est recueilli en O sur le drain du même transistor. La puissance consommée (0,3 - 1mW) par cet inverseur de base

$$P \simeq V_{DD} \frac{I_1}{-2} + kf$$

est proportionnelle à la fréquence de travail (kf) mais comporte un terme constant qui correspond à la consommation de la charge active 2, même si l'inverseur est au repos.

Le cas d'un inverseur en logique BFL (Buffered Fet Logic) est encore plus caractéristique car - mis à part le fait que tous les transistors sont à déplétion - l'inverseur de la figure 1 est suivi d'un étage décaleur qui consomme également au repos, ce qui fait que la puissance consommée est de l'ordre de 5 à 10 mW.

Par ailleurs, il est connu que les MOS complémentaires, sur silicium, présentent l'avantage d'avoir une consommation nulle au repos et une consommation proportionnelle à la fréquence (kf) au travail. C'est pourquoi il est souhaitable de disposer pour la logique rapide - qui correspond aux microondes et aux gigahertz - d'un dispositif comparable aux MOS complémentaires, qui sont limités actuellement à environ 1 à 3 GHz.

Des circuits ont été réalisés en ce sens, au moyen de deux transistors de type HIGFET (Hétérostructure Insulated Gate Fet, en anglais) ou transistors à effet de champ à hétérostructre, dont l'un a un canal n et l'autre un canal p. L'hétérostructure - c'est à dire par définition une ou plusieurs jonctions entre deux ou plusieurs couches de matériaux différents du groupe III-V, par exemple GaAs et GaInAs - est intéressante parce que c'est - parmi d'autres- l'une des bases des transistors rapides dits TEGEETs ou HEMTs (High Electronic Mobility Transistors) et que les HIGFETs ont une excellente uniformité de tension de seuil $V_T$ sur une tranche, en fabrication. Cette tension de seuil est très peu dépendante de la température et est très peu sensible à la lumière parce qu'elle n'est pas contrôlée par des dopants.

Un premier inconvénient des HIGFETs, dans leurs structures connues, est que les deux transistors n et p ont des tensions de seuils différentes, en valeurs absolues, ce qui ne convient pas aux opérations logiques puisque les impulsions logiques - les bits- doivent avoir la même amplitude quelle que soit le transistor qui est en service.

Un second inconvénient des HIGFETs connus est la différence de transconductance entre les deux canaux : de l'ordre de 218 mS/mm pour le canal n et 28 mS/mm pour le canal p, à la température ambiante dans les deux cas. Cette différence s'explique encore par la faible mobilité des trous $\mu_h$ à la température ambiante.

L'invention propose une nouvelle structure pour un dispositif semiconducteur comportant au moins deux transistors à hétérostructure entre matériaux de la famille III-V, l'un au moins parmi ces transistors ayant un canal de type n, à électrons, et au moins un autre transistor ayant un canal de type p, à trous. Cette structure est caractérisée par la présence d'une dépression obtenue par gravure, dans la région du canal n et par le fait que les transistors n et p sont réalisés de façon indépendante , ce qui permet de les ajuster séparément.

Un autre objet de l'invention est d'optimiser de façon indépendante les tensions de seuils $V_{Tn}$ et $V_{Tp}$, au moyen d'au moins deux plans de dopage, dont l'un est compris dans la couche superficielle épargnée par la gravure de la dépression.

Un autre objet de l'invention est de symétriser et d'améliorer le rapport des transonductances.

Un autre objet de l'invention est de permettre le fonctionnement de portes logiques sous une tension d'alimentation $V_{DD}$ réduite ($\sim$ 1 V) sans dégradation des performances, ce qui permet une plus grande complexité de circuit logique sans consommation excessive parce que les courants de grille sont négligeables.

Un autre objet de l'invention est de disposer d'un dispositif semiconducteur dont le procédé de fabrication, et en particulier la gravure sélective, est compatible avec les procédés industriels actuels de fabrication de transistors à effets de champ pour les circuits VLSI.

De façon plus précise, l'invention concerne un dispositif semiconducteur à transistors complémentaires, comportant au moins deux transistors à effet de champ réalisés au moyen d'une hétérostructure de couches de matériaux semiconducteurs du groupe III-V, l'un de ces transistors ayant un canal de type n (2DEG) et au moins un autre ayant un canal type p (2DHG), ces deux canaux étant situés à la même hétérojonction dans l'hétérostructure, ce dispositif étant caractérisé en ce qu'il comporte dans deux couches distinctes de l'hétérostructure, au moins deux plans de dopages situés entre les canaux (2 DEG et 2 DHG) et les métallisations de grilles des transistors, le premier de ces plans de dopage étant de type p et le second étant de type n.

L'invention sera mieux comprise par l'exposé d'un exemple d'application, en liaison avec les figures jointes en annexe, qui représentent :

- figure 1 : schéma électrique d'un inverseur selon l'art connu,
- figure 2 : schéma électrique d'un inverseur en logique complémentaire, connu mais qui est cependant celui du dispositif selon l'invention,
- figure 3 : caractéristique $I_G = f (V_{GS})$,
- figure 4 : coupe d'un circuit intégré comportant un n HIGFET et un p HIGFET, selon l'art connu,
- figure 5 : coupe d'un circuit intégré comportant deux transistors à hétérostructures et à canaux n et p, selon l'invention.

La figure 2 représente le schéma électrique d'un inverseur, ou logique complémentaire, selon l'invention : il comporte deux transistors à enrichissement 3 et 4 montés en série entre une alimentation $V_{DD}$ et la masse, l'un des transistors 3 ayant un canal n et l'autre ayant un canal p. Par rapport à un inverseur DCFL. La différence est que le signal d'entrée est appliqué simultanèment sur les deux grilles des deux transistors 3 et 4. Ce schéma n'est pas différent de celui d'une paire MOS complémentaire : toute la difficulté est de la réaliser en matériaux III-V pour faire une logique rapide, alors que les C. MOS sur silicium sont réputés lents.

En effet, si la consommation pour cette paire de transistors 3 et 4 est nulle en statique, et proportionnelle à la fréquence en dynamique (kf), il y a néanmoins deux conditions importantes pour les deux types de transistors.

Il faut d'abord que la tension de seuil $V_T$ soit, en valeur absolue , sensiblement égale au cinquième de la tension maximale grille-source

$$|V_T| \simeq 1/5 \ |V_{GS \ max}|$$

La tension $V_{GSmax}$ est représentée sur la figure 3 : elle est de l'ordre de 0,6 V pour les MESFETs et de 1 V pour les TFGFETs ou HEMTs. Imposée par la hauteur de barrière de la grille Schottky d'un transistor, c'est la tension au-delà de laquelle il y a une fuite de courant par la grille. L'impulsion de tension maximale de grille est limitée par le courant de fuite de grille qui diminue donc aussi la marge de bruit. En outre, le courant de fuite de grille conduit à une décroissance du courant de saturation de drain, ce qui réduit la vitesse maximale de fonctionnement du système.

Le facteur 1/5 est choisi arbitrairement, car l'excursion logique ne peut pas être inférieure à $V_T$ (elle est sans action sur le transistor), mais ne doit pas être supérieure a $V_{Gs \ max}$. Ceci permet une excursion logique 4/5 $V_{GSmax}$ pour chaque transistor (n et p), à laquelle correspond un courant de saturation $I_{D \ max} = f (4/5 \ V_{GS \ max})$.

En outre, une seconde condition importante est que ces deux tensions de seuils soient sensiblement égales en valeur absolue, de façon à symétriser le fonctionnement de l'inverseur.

Une autre condition, qui peut être résolue indépendamment, est que les transconductances soient sensiblement égales.

La figure 4 représente une vue en coupe d'un circuit intégré comportant un n HIGFET et un p HIGFET, publié dans IEEE EDL, vol. ED1, vol. EDL 6, n° 12, december 1985, pp 645... Sur un substrat 5 de GaAs non intentionnellement dopé (nid), on fait croître une couche 6 de AlGaAs non intentionnellement dopé : il y a donc hétérojonction entre deux matériaux différents, et semi isolants. Des métallisations de grilles 7 et 8, réfractaires en W Si, sont déposées avant deux implantations qui créent des régions autoalignées dopées n autour d'une grille (7) et d'autres régions autoalignées dopées p autour d'une autre grille (8). Des régions de prises de contacts surdopées $n^+$ et $p^+$ permettent de déposer les contacts ohmiques de source et drain 9 et 10 sur le transistor n, et 11 et 12 sur le transistor p. Les implantations sont assez profondes pour atteindre le niveau de l'hétérojonction : les conditions sont donc réunies pour avoir un gaz bidimentionnel d'électrons (2 DEG) comme canal n, et un gaz bidimentionnel de trous (2 DHG) comme canal p. (Les abréviations 2 DEG ET 2 DHG se sont imposées dans la littérature scientifique internationale).

L'inconvénient de ce système , par ailleurs très simple, est que pour le couple GaAs/ $Al_x Ga_{1-x}$ As, avec x = 0,3

$$V_{Tn} \simeq + 0,78 \ V$$
$$V_{Tp} \simeq - 0,65 \ V$$

Si $V_{GS \ max} \simeq 1$ V pour un HEMT, l'excursion utile à la génération de courant $V_{GS \ max} - V_T \simeq 0,3 / 0,35$ V est faible, et la logique est relativement lente.

Une première amélioration consiste à établir les canaux 2 DEG et 2 DHG des deux transistors dans un matériau du groupe III-V ayant une bande interdite plus faible que celle de GaAs, par exemple InGaAs à la place de GaAs, qui améliore le transistor à canal p

$$V_{Tp} = -0,38 \ V$$

mais ne modifie pas le transistor à canal n

$$V_{Tn} = +0,78 \ V$$

Pour équilibrer les tensions de seuils, et répartir le gain obtenu entre les deux types de transistors, une deuxième amélioration apportée par l'invention consiste à introduire des plans de dopages avant, c'est à dire entre la grille et le canal.

La technique du plan de dopage, connu en anglais sous l'appelation "Delta doped layer", est en soi connue : elle consiste à introduire une impureté de dopage (silicium ou beryllium par exemple) au cours de la croissance épitaxiale d'une couche non dopée de matériau semiconducteur, localisée dans un film de quelques épaisseurs atomiques noyé dans la couche non dopée.

Dans les cas connus, l'unique plan de dopage est arrière, c'est à dire entre le canal et le substrat, et les tensions de seuils sont données par les équations

$$V_{Tn} = \phi_m - \Delta E_c - (\sigma/\varepsilon) \ d$$
$$V_{Tp} = \phi_m - \Delta E_c - E_{g2} - (\sigma/\varepsilon) \ d$$

dans lesquelles :
- $\sigma$ est la charge électrique par unité de surface du plan de dopage,
- $\varepsilon$ est la permittivité diélectrique
- d est la distance du canal à la grille.

On peut alors choisir la nature du dopage et la charge $\sigma$ pour que les tensions de seuils soient égales en valeur absolue

$$|V_{Tn}| = |V_{Tp}| \simeq 1/2 \ V_{GSmax} \simeq 0,5 \ V$$

mais cette solution entraîne une logique peu rapide parce que l'excursion logique $1/2 \ V_{GSmax}$ est plus petite que l'excursion souhaitée $4/5 \ V_{GSmax}$.

Augmenter la tension d'alimentation $V_{DD}$ pour augmenter la vitesse de basculement des transistors n'est pas une bonne solution car, au delà de 1,25 V environ, il y a dépassement de la barrière de grille Schottky et augmentation de la consommation statique par fuite par la grille.

C'est pourquoi la seconde amélioration apportée par l'invention, citée plus haut, consiste à introduire au moins deux plans de dopage avant, entre le canal et la métallisation de grille, ce qui permet d'optimiser les deux tensions de seuils $V_{Tn}$ et $V_{Tp}$ au moyen de deux agents dopants, chacun au niveau de dopage nécessaire, ces deux plans de dopage n'étant pas confondus dans un même plan géométrique, mais superposés, ce qui permet d'en isoler un par gravure localisée.

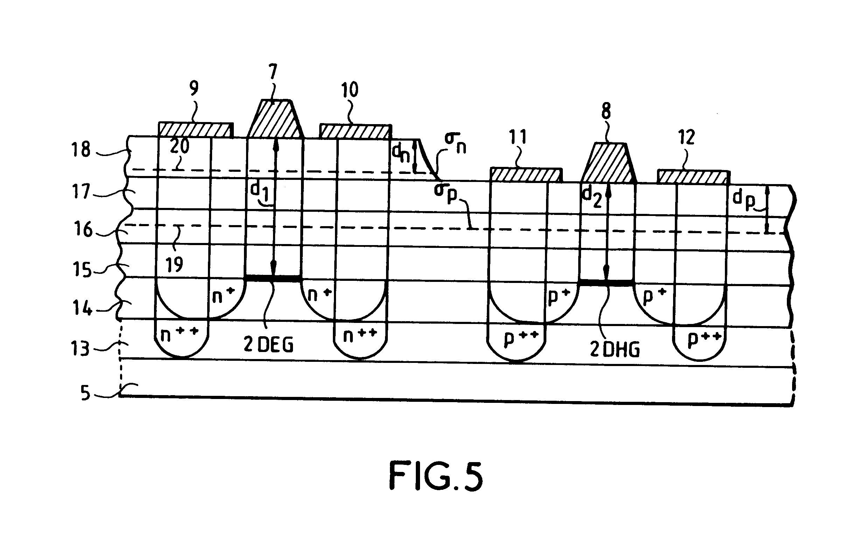

La figure 5 représente une coupe du dispositif de deux transistors complémentaires n et p selon l'invention. On y a conservé les repères communs avec les transistors antérieurs de la figure 4. Les matériaux et le nombre des couches n'y sont donné qu'à titre d'exemple non limitatif.

Sur un substrat 5 en GaAs semi-isolant, on fait croitre successivement par épitaxie :
1) une couche tampon ou de lissage 13 en GaAs non intentionellement dopé, sur 5000 A° d'épaisseur,
2) une couche 14 de In $Ga_{1-x}$ As ($x \simeq 0,25$), d'environ 150 A° d'épaisseur , dans laquelle se développent soit un gaz d'électron 2 DEG, soit un gaz de trous 2 DHG à l'hétérojonction avec la couche suivante,
3) une couche 15 de $Al_x Ga_{1-x}$ As ( $x \simeq 0,75$) sur 100A° d'épaisseur.
4) une couche 16 de GaAs, de 50 A° d'épaisseur, comportant en 19 un plan de dopage a sur lequel on reviendra plus loin,
5) une couche 17 de $Al_y \ Ga_{1-y}$ As y $\simeq 0,3$) qui constitue à la fois une couche d'arrêt pour la gravure sélective de GaAs et une couche barrière d'épaisseur 50 A° pour le transistor à canal p,
6) une couche 18 de GaAs, de 100 A° d'épaisseur, comportant un plan de dopage $\sigma n$ en 20.

Après croissance épitaxiale de toutes ces couches, une gravure RIE sélective et localisée de la couche 18 permet d'éliminer le plan de dopage 20 de type n au dessus du futur transistor de type p, ce qui rend $V_{Tn}$ et $V_{Tp}$ indépendants. Cette gravure intervient dès le début du procédé de réalisation.

Le plan de dopage 19 est destiné à ajuster $V_{Tp}$. Il est situé approximativement à mi-épaisseur de la couche 16 de GaAs, à une distance $d_p$ du plan de la grille 8 du transistor à canal p. La charge $\sigma_p$ est réglée - par la dose du delta-dopage - pour obtenir le $V_{Tp}$ recherché.

Le plan de dopage 20 est destiné à ajuster $V_{Tn}$. Il est situé à une distance $d_n$ du plan de la grille 7 du transistor à canal n qui est de l'ordre de 90 A° (dans une couche 18 de 100 A°). Le réglage de la charge $\sigma_n$ doit tenir compte du fait que ce transistor à canal n comprend en outre le plan de dopage 19 de charge $\sigma$.

En vue de simplifier la figure 5 n'ont été représentés que deux plans de dopages 19 et 20. Il est évident pour l'homme de l'art que chacun de ces plans de dopages peut être remplacé par deux ou plusieurs plans 19a, 19b, 19c... et 20a, 20b, 20c...car la technique en est très simple; la seule condition est que l'ensemble des plans d'un type donné apporte les mêmes $\sigma_n$ $d_n$ ou $\sigma_p$ $d_p$ qu'un unique plan du même type, 19 ou 20.

Les caissons de prises de contacts de types $n^+$ et $p^+$ qui jouxtent les canaux 2 DEG et 2 DHG sont réalisés par implantations avec autoalignement sur les grilles 7 et 8 en WSi, puis les contacts ohmiques 9 à 12 sont déposés, selon les procédés bien connus de réalisations industrielles de MESFETs.

La structure décrite, dans laquelle le plan de dopage 20 de type n est au dessus du plan de dopage 19 de type p, est préférable à une structure inverse. En effet, selon la structure décrite on a

$$d_1 > d_2$$

avec

$$d_1 = \text{distance canal 2 DEG/grille 7 (transistor n)}$$
$$d_2 = \text{"} \qquad \text{"} \quad \text{2 DHG/grille 8 (transistor p).}$$

Ceci permet de compenser en partie la mobilité des trous inférieure à la mobilité des électrons.

Pour le transistor à canal p (2 DHG) qui ne comporte qu'un seul plan de dopage 19, la tension de seuil $V_{Tp}$ est définie par :

$$V_{Tp} = V°_{Tp} + (|\sigma p|/\varepsilon)\, d_p$$

dans laquelle $V°_{Tp} \simeq -0{,}38$ V est la tension de seuil sans plan de dopage 19.

Pour obtenir

$$V_{Tp} \simeq 1/5\, V_{GS\,max} \simeq -\,0{,}2\,V$$

qui est une valeur souhaitée pour que l'excursion logique soit 4/5 $V_{GSmax}$, et avec $d_p \simeq 70$ A° ( 50A° dans la couche 17 + 20 A° dans la couche 16), on calcule que la densité surfacique

$$D_p \simeq 1{,}4.10^{12}\ at.cm^{-2}$$

Le plan de dopage 19 est réalisé par dopage au Be.

Pour le transistor à canal n (2DEG), avec deux plans de dopages 19 et 20, la tension de seuil $V_{Tn}$ est définie par

$$V_{Tn} = V°_{Tn} - (\sigma_n/\bar{\varepsilon})d_n + (|\sigma_p|/\bar{\varepsilon})d_p$$

ou $V°_{Tn} \simeq +0{,}78$ V est la tension de seuil sans les plans de dopages 19 et 20.

$\sigma_p$ est déjà déterminée par le calcul de $V_{Tp}$ : pour obtenir

$$V_{Tn} \simeq 1/5\, V_{GS\,max} \simeq +\,0{,}2\,V$$

ce qui symétrise l'inverseur logique, et avec $d_n \simeq 90$ A°, on trouve que

$$D_n \simeq 7.10^{12}\ at.cm^{-2}$$

La couche dopée 20 est réalisée au moyen de Si.

Ainsi, l'utilisation de deux plans de dopage avant, c'est à dire situés entre la grille et le canal, conjuguée avec une gravure sélective qui supprime partiellement l'un de ces plans de dopage, permet de réaliser un inverseur à transistors à effet de champ complémentaires, en matériaux III-V pour la logique rapide. En effet, la suppression par gravure de l'un des deux plans de dopage permet l'optimisation indépendante des deux tensions de seuil, ainsi que l'optimisation indépendante de la transconductance $g_m$ des deux transistors.

Ceux-ci peuvent fonctionner avec une tension d'alimentation $V_{DD}$ réduite ($\simeq$1V) sans dégradation des performances, parce qu'on a choisi $V_{GS}$ max < 1V. Les tensions de seuil faibles autorisent une grande excursion logique , d'où il résulte une capacité des transistors à fournir plus de courant pendant les transitoires, et donc des performances élevées de changement d'état : $T_{pd} < 50$ ps.

L'invention a été décrite en s'appuyant sur un exemple dans lequel les compositions et les épaisseurs des couches sont citées dans le seul objet de simplifier l'exposé. Il est évident que le dispositif selon l'invention peut-être réalisé avec n'importe lesquels des composés du groupe III-V (Al,Ga,In, P, As) sous forme d'alliages binaires, ternaires ou quaternaires, si ces composés forment deux transistors à hétérojonction, à canaux n et p, comportant au moins deux plans de dopages "avant" , selon l'esprit de l'invention qui est précisée par les revendications suivantes.

## Revendications

1.  Dispositif semiconducteur à transistors complémentaires, comportant au moins deux transistors à effet de champ réalisés au moyen d'une hétérostructure de couches (13 à 18) de matériaux semiconducteurs du groupe III-V, l'un au moins parmi ces transistors ayant un canal de type n (2 DEG) et au moins un autre ayant un canal de type p (2 DHG), ces deux canaux étant situés à la même hétérojonction (14/15) dans l'hétérostructure (13 à 18), ce dispositif étant caractérisé en ce qu'il comporte, dans deux couches distinctes (16, 18) de l'hétérostructure, au moins deux plans de dopages (19, 20) situés entre les canaux (2 DEG et 2 DHG) et les métallisations de grilles (7, 8) des transistors, le premier de ces plans de dopage (19) étant de type p et le second (20) étant de type n.

2. Dispositif à transistors complémentaires selon la revendication 1, caractérisé en ce que, dans l'hétérostructure, le premier plan de dopage (19) de type p est situé entre le second plan de dopage (20) de type n et l'hétérojonction (14/15) qui contient les deux canaux (2 DEG, 2DHG).

3. Dispositif à transistors complémentaires selon la revendication 2, caractérisé en ce que le second plan de dopage (20) est situé dans la couche superficielle (18) de l'hétérostructure, et en ce que ledit second plan de dopage (20) est localement éliminé, à l'aplomb du transistor à canal p (2 DHG), par gravure sélective localisée de ladite couche superficielle (18).

4. Dispositif à transistors complémentaires selon la revendication 3, caractérisé en ce que le niveau de dopage ($\sigma_p$) du premier plan de dopage (19) commande la tension de seuil $V_{Tp}$ du transistor à canal p (2 DHG).

5. Dispositif à transistors complémentaires selon la revendication 3, caractérisé en ce que le niveau de dopage ($\sigma_n$) du second plan de dopage (20) commande la tension de seuil $V_{Tn}$ du transistor à canal n (2 DEG), compte tenu du niveau de dopage ($\sigma_p$) du premier plan de dopage (19).

6. Dispositif à transistors complémentaires selon l'une quelconque des revendications 4 ou 5, caractérisé en ce que les tensions de seuil $V_{Tn}$ et $V_{Tp}$ des deux types de transistors sont sensiblement égales en valeurs absolues, et sont calculées pour être de l'ordre de 1/5 $V_{GSmax}$, tension grille-source maximale.

7. Dispositif à transistors complémentaires selon la revendication 3, caractérisé en ce que la distance $d_1$ entre le canal (2 DEG) et la grille (7) est pour le transistor à canal n plus grande que la distance $d_2$ entre le canal (2 DHG) et la grille (8) pour le transistor à canal p.

8. Dispositif à transistors complémentaires selon la revendication 1, caractérisé en ce que l'hétérostructure de matériaux semiconducteurs du groupe III-V comprend :
   - un substrat (5) ou un premier matériau semi-isolant de type GaAs, recouvert d'une couche tampon (13) du même matériau non-intentionnellement dopé ;
   - une couche (14) d'un second matériau, de type InGaAs, formant une hétérojonction avec une couche (15) d'un troisième matériau, de type AlGaAs ;
   - une couche (16) du premier matériau (GaAs) comportant le premier plan de dopage (19) de type p ($\sigma_p$) ;
   - une couche (17) d'arrêt, du troisième matériau (AlGaAs), pour la gravure sélective localisée ;
   - une couche superficielle (18), du premier matériau (GaAs), comportant le second plan de dopage (20) de type n ($\sigma_n$).

FIG.1

FIG.2

FIG.3

FIG.4

7

FIG.5

EP 0 565 435 A1

EP 0 565 435 A1

| | Office européen<br>des brevets | RAPPORT DE RECHERCHE EUROPEENNE | Numero de la demande<br>EP 93 40 0893<br>Page 1 |
|---|---|---|---|

## DOCUMENTS CONSIDERES COMME PERTINENTS

| Catégorie | Citation du document avec indication, en cas de besoin,<br>des parties pertinentes | Revendication<br>concernée | CLASSEMENT DE LA<br>DEMANDE (Int. Cl.5) |
|---|---|---|---|
| A | EP-A-0 256 363 (HONEYWELL INC)<br>* abrégé; figures *<br>--- | 1-8 | H01L27/06<br>H01L29/76<br>H01L29/36 |
| A | EP-A-0 312 237 (AMERICAN TELEPHONE AND TELEGRAPH COMPANY)<br>* abrégé; figures *<br>--- | 1-8 | |
| A | EP-A-0 114 962 (INTERNATIONAL BUSINESS MACHINES CORPORATION)<br>* abrégé; figures *<br>--- | 1-8 | |
| A | PATENT ABSTRACTS OF JAPAN<br>vol. 11, no. 130 (E-502)23 Avril 1987<br>& JP-A-61 276 269 ( FUJITSU LTD ) 6 Décembre 1986<br>* abrégé *<br>--- | 1-8 | |
| A | PATENT ABSTRACTS OF JAPAN<br>vol. 11, no. 288 (E-542)(2735) 17 Septembre 1987<br>& JP-A-62 089 365 ( FUJITSU LTD ) 23 Avril 1987<br>* abrégé *<br>--- | 1-8 | **DOMAINES TECHNIQUES RECHERCHES (Int. Cl.5)**<br><br>H01L |
| A | THIRD INTERNATIONAL CONFERENCE ON INDIUM PHOSPHIDE AND RELATED MATERIALS Avril 1991, CARDIFF, WALES, GREAT BRITAIN<br>pages 238 - 241<br>S. SWIRHUN ET AL. 'P- and N-channel InAlAs/InGaAs Heterojunction Insulated Gate FETs (HIGFETs) on InP'<br>* page 238, alinéa 4; figure 1 *<br>--- | 1-8 | |
| A | SOLID STATE TECHNOLOGY<br>vol. 34, no. 11, Novembre 1991, WASHINGTON US<br>page 26 'New GaAs IC technology'<br>* figure *<br>---<br>-/-- | 1-8 | |

Le présent rapport a été établi pour toutes les revendications

| Lieu de la recherche<br>LA HAYE | Date d'achèvement de la recherche<br>24 MAI 1993 | Examinateur<br>SINEMUS M. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P0402)

9

EP 0 565 435 A1

Office européen
des brevets

**RAPPORT DE RECHERCHE EUROPEENNE**

Numero de la demande

EP    93 40 0893
Page 2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| A | PATENT ABSTRACTS OF JAPAN vol. 11, no. 359 (E-559)21 Novembre 1987 & JP-A-62 133 768 ( FUJITSU LTD ) 16 Juin 1987 * abrégé * | 1-8 | |
| | ----- | | |
| | | | **DOMAINES TECHNIQUES RECHERCHES (Int. Cl.5 )** |

Le présent rapport a été établi pour toutes les revendications

| Lieu de la recherche | Date d'achèvement de la recherche | Examinateur |
|---|---|---|
| LA HAYE | 24 MAI 1993 | SINEMUS M. |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons

& : membre de la même famille, document correspondant

EPO FORM 1503 01.82 (P0402)

10